# EUROPÄISCHE PATENTSCHRIFT

(11) **EP 1 723 402 B1**
(45) Veröffentlichungstag und Bekanntmachung des Hinweises auf die Patenterteilung: **18.07.2007**
(21) Anmeldenummer: 05729617.0
(22) Anmeldetag: 05.03.2005
(51) Int. Cl.: G01M 3/28, B81C 5/00, H01L 21/66

(54) **PRÜFUNG DER DICHTIGKEIT VON SCHEIBENBONDVERBINDUNGEN UND TESTSTRUKTUR ZUR DURCHFÜHRUNG DES VERFAHRENS**
TIGHTNESS TEST FOR DISK BOND CONNECTIONS AND TEST STRUCTURE FOR CARRYING OUT SAID METHOD
VERIFICATION DE L'ETANCHEITE DES CONNEXIONS DE PLAQUETTES PAR METALLISATION, ET STRUCTURE DE VERIFICATION SERVANT A LA MISE EN OEUVRE DE CE PROCEDE

(30) Priorität: 06.03.2004 DE 102004011035
(43) Veröffentlichungstag der Anmeldung: 22.11.2006
(73) Patentinhaber: X-FAB Semiconductor Foundries AG, 99097 Erfurt (DE)
(72) Erfinder: KUMST, Ronald, 99092 Erfurt (DE)
(74) Vertreter: Leonhard, Frank Reimund
(86) Internationale Anmeldenummer: PCT/EP2005/050993
(87) Internationale Veröffentlichungsnummer: WO 2005/085791

(56) Entgegenhaltungen:
- EP-A- 0 794 558
- US-A- 6 106 735
- WAELTI M ET AL: "PACKAGE QUALITY TESTING USING INTEGRATED PRESSURE SENSOR" INTERNATIONAL JOURNAL OF MICROCIRCUITS AND ELECTRONIC PACKAGING, INTERNATIONAL MICROELECTRONICS & PACKAGING SOCIETY, US, Bd. 22, Nr. 1, Januar 1999 (1999-01), Seiten 49-56, XP000827216 ISSN: 1063-1674
- LAPADATU A C ET AL: "A new concept for a self-testable pressure sensor based on the bimetal effect" SENSORS AND ACTUATORS A, ELSEVIER SEQUOIA S.A., LAUSANNE, CH, Bd. 82, Nr. 1-3, Mai 2000 (2000-05), Seiten 69-73, XP004198240 ISSN: 0924-4247
- BERGSTROM P L ET AL: "THERMALLY DRIVEN PHASE-CHANGE MICROACTUATION" JOURNAL OF MICROELECTROMECHANICAL SYSTEMS, IEEE INC. NEW YORK, US, Bd. 4, Nr. 1, 1. März 1995 (1995-03-01), Seiten 10-17, XP000506489 ISSN: 1057-7157

## Beschreibung

Die Erfindung betrifft ein Verfahren und eine Anordnung zur Qualitätsüberwachung, also eine Dichtigkeitsprüfung von Scheibenbondverbindungen wie sie beispielsweise zur Herstellung von MEMS (mikroelektromechanische Strukturen) angewendet werden, indem beispielsweise Glas- und Siliziumscheiben zur Erzeugung hermetisch dichter Hohlräume bzw. Kavitäten gebildet werden, in denen sich der mikromechanische Sensorteil befindet. Solche Sensorteile erfordern eine hohe Dichtigkeit des Hohlraumes, da die Zuverlässigkeit und Lebensdauer des Bauelements in hohem Maße von der Dichtigkeit der Scheibenverbindung abhängig ist.

Im Normalfall wird so vorgegangen, dass bei der Ausarbeitung des Bondverfahrens mit Hilfe von speziellen Kontrollmethoden, z. B. mittels Infrarotmikroskopie, die Dichtigkeit geprüft wird und in Abhängigkeit davon die Verfahrensparameter optimiert werden. Undichtigkeiten, welche sich im laufenden Fertigungsbetrieb ergeben können, zeigen sich erst viel später durch Datenänderung der fertigen Bauelemente. Das Aussortieren der fertigen Bauelemente ist jedoch ein relativ teures Verfahren, da dann ein großer Teil sehr aufwendiger und komplexer Prozessschritte für Bauelemente, die dann nicht den geforderten Spezifikationen entsprechen, aufzuwenden war.

Im Stand der Technik sind diverse Verfahren zur Prüfung von Hohlräumen in Scheibenbondverbindungen beschrieben, die jedoch zur Prüfung der Dichtigkeit von Hohlräumen unter Produktionsbedingungen nur bedingt geeignet sind.

So zeigt beispielsweise Nese et al., "New method for testing hermeticity of silicon sensor structures", A 53 (1996), Seiten 349 bis 352 ein Verfahren zur Beurteilung von Halbleiterscheibenbondverfahren hinsichtlich der hermetischen Dichtigkeit, bei dem die Gaskonzentration in dem hermetisch dichten Hohlraum eines Testchips mittels FTIR-Spektroskopie (Fourier-Transform-Infrared-Spektroskopie) gemessen wird.

DE-B 197 39 961 beschreibt ein Verfahren zur Bestimmung des Gasdrucks in einem Hohlraum mit verformbaren Wänden eines Halbleiterbauelements, das auf einer Resonanzfrequenzmessung beruht. Weiterhin ist aus DE-A 101 36 219 ein Verfahren bekannt, bei dem zur Dichtigkeitsprüfung von hermetisch dichten Sensoren eine Kapazitätsmessung der unter definierten Bedingungen in einer Prüfflüssigkeit getauchten Prüflinge vorgenommen wird, wobei im speziellen Falle die Prüflinge vorher einem Vakuum ausgesetzt waren.

Waelti et al., "Package quality testing using integrated pressure sensor", International Journal of Microcircuits and Electronic Packaging, Bd. 22, Nr. 1, Januar 1999, Seiten 49-56 zeigt einen integrierten thermischen Drucksensor, der zum Überwachen der Dichtigkeitsqualität einer hermetischen Packung.

Lapadatu A C et al., "A new concept for a self-testable pressure sensor based on the bimatel effect", Sensors and Actuators A, Bd. 82, Nr. 1-3, Mai 2000, Seiten 69-73 zeigt einen Drucksensor mit zwei Membranen und mit integriertem Selbsttest.

Es ist Aufgabe der Erfindung, eine Technik zur Dichtigkeitsprüfung anzugeben, die in relativ kurzer Zeit zu einem sicheren Ergebnis führt, so dass damit die Dichtigkeitsprüfung auch im Rahmen einer Fertigungskontrolle im Scheibenprozess anwendbar ist.

Die Aufgabe wird gemäß einem ersten Aspekt der vorliegenden Erfindung durch ein Verfahren zur Bewertung der Dichtigkeit von Scheibenverbindungen gelöst, wobei das Verfahren das Herstellen einer Teststruktur umfasst. Die Teststruktur wird durch Bilden einer mikromechanischen Sensorstruktur und einer benachbarten Schmelzstruktur mit elektrischen Leitbahnen und ersten Kontaktierinseln, die mit der mikromechanischen Sensorstruktur verbunden sind, und zweiten Kontaktierinseln, die mit der Schmelzstruktur verbunden sind, auf einer Basisscheibe gebildet, und se wird ein Hohlraum durch Verbinden einer Deckscheibe mit der Basisscheibe so geschaffen, dass die mikromechanische Sensorstruktur und die Schmelzstruktur in dem Hohlraum liegen. Ferner umfasst das Verfahren Einprägen eines Stromes in die zweiten Kontaktierinseln, um zum Zwecke der Dichtigkeitsprüfung des Hohlraums die Schmelzstruktur zum Schmelzen zu bringen, wodurch eine Druckänderung im Innenbereich des Hohlraums erzeugt wird, welche in ihrem zeitlichen Verlauf mit Hilfe der mikromechanischen Sensorstruktur gemessen wird.

Mittels dieser Technik können fehlerhafte Scheibenverbindungen unmittelbar nach dem Bondprozess erkannt und so frühzeitig aus dem Prozess ausgeschleust werden. Dadurch werden Fertigungskosten eingespart und die Langzeitzuverlässigkeit der Bauelemente wird erhöht. Da ferner die Bewertung der Dichtigkeit generell von innen erfolgt, haben Umwelteinflüsse keinen oder nur sehr geringen Einfluss auf die Druckbewertung des Hohlraums. Ferner lässt sich der Aufwand hinsichtlich der Testausrüstung relativ gering halten.

In einer weiteren vorteilhaften Ausführungsform umfasst das Verfahren ferner das Herstellen mehrerer mikroelektromechanischer Strukturen (MEMS) auf der Scheibenverbindung.

Damit lässt sich insbesondere auch die Dichtigkeit bzw. Zuverlässigkeit der MEMS während des Herstellungsprozesses sehr präzise bestimmen, da die den Prozess der Herstellung der Teststruktur betreffenden Verfahrensparameter im Wesentlichen in identischer Weise auch die Herstellung der MEMS-Strukturen beeinflussen.

In einer weiteren vorteilhaften Ausführungsform werden mehrere Teststrukturen an bestimmten Stellen der Scheibenverbindung hergestellt.

Auf diese Weise lässt sich eine sehr effiziente Prozessüberwachung gewährleisten, die auch Fluktuationen von Prozessparameter erkennen lässt, die sich in sehr lokaler Weise über die Scheibenfläche hinweg auswirken.

In einer weiteren Ausführungsform wird die unter dem veränderten Druck stehende Teststruktur gezielt Stress-Bedingungen ausgesetzt, wobei durch Vergleich der Messwerte der mikromechanischen Sensorstruktur vor und nach dem Ausüben der Stressbedingung Aussagen zur Zuverlässigkeit gewonnen werden.

Auf Grund dieser Beaufschlagung mit einer gegebenen Belastung bzw. einem Stress kann das Verhalten der Teststruktur und damit auch anderer Bauelemente bzw. die Eigenschaft der Scheibenverbindung insgesamt bewertet werden, so dass damit auch Aussagen über das künftige Verhalten der Teststruktur oder anderer Bauelemente möglich sind. Beispielsweise kann der vordefinierte Stress den Betrieb bei gewissen Temperaturbedingungen, beispielsweise bei erhöhten oder geringen Temperaturen, und/ oder den Betrieb bei gewissen Feuchtigkeitsbedingungen und/oder den Betrieb bei gewissen mechanischen Belastungen und dergleichen mit einschließen. So kann beispielsweise aus dem Betrieb bei erhöhten Temperaturen und den aus diesem Betrieb erkannten Verhalten der Teststruktur hinsichtlich der Dichtigkeitsänderung auf die zu erwartende Alterung der Teststruktur bzw. anderer Bauelemente geschlossen werden.

In einer weiteren Ausführungsform werden die mehreren Teststrukturen entsprechend vorgegebenen Kriterien der Qualitätsüberwachung für die mikroelektromechanischen Strukturen angeordnet.

Gemäß einem weiteren Aspekt der vorliegenden Erfindung wird ein Verfahren zur Überwachung einer mikroelektromechanischen Struktur bereitgestellt. Das Verfahren umfasst das Herstellen einer Teststruktur gemäß einem Herstellungsverfahren, wie es in den vorhergehenden Ausführungsformen beschrieben ist. Ferner umfasst das Verfahren das Herstellen der mikroelektromechanischen Struktur so, dass diese einen funktionellen Verband mit der Teststruktur bildet. Des weiteren wird die mikroelektromechanische Struktur betrieben und es wird ein Strom in die Schmelzstruktur der Teststruktur eingeprägt. Schließlich werden die Messwerte der mikromechanischen Sensorstruktur ausgewertet, um eine Online-Überwachung der mikroelektromechanischen Struktur durchzuführen.

Durch das Ausbilden der Teststruktur und der MEMS als Verband kann auch nach dem Vereinzeln der Bauelemente die Funktion der MEMS auch während der Phase der Anwendung überwacht werden.

In einer weiteren Ausführungsform weist die Schmelzstruktur der Teststruktur mehrere Sollschmelzstellen auf, wobei das Verfahren ferner umfasst: Auslösen eines Schmelzvorgangs der mehreren Sollschmelzstellen nacheinander und Bewerten der Messergebnisse, die von der mikromechanischen Sensorstruktur erhalten werden, um die Online-Überwachung auszuführen.

Damit lässt sich die Online-Überwachung flexibler gestalten, die zu verschiedenen Zeitpunkten Messwerte gewonnen werden können. Ferner lässt sich auch die Teststruktur auch bereits während der Herstellungsphase des Verbands zur Ermittlung von Messdaten verwenden.

Gemäß einem weiteren Aspekt der vorliegenden Erfindung wird eine Teststruktur zur Prüfung der Dichtigkeit von Scheibenbondverbindungen bereitgestellt. Die Teststruktur umfasst einen Bereich einer Basisscheibe, einen Bereich einer Deckscheibe und einen Hohlraum, der durch Scheibenverbindung der Basisscheibe und der Deckscheibe gebildet ist. Ferner umfasst die Teststruktur eine drucksensitive mikromechanische Struktur, die in dem Hohlraum (5) angeordnet ist, und eine Schmelzstruktur, die in dem Hohlraum angeordnet ist. Die Teststruktur umfasst ferner erste Kontaktierinseln, die außerhalb des Hohlraums liegen und mit der drucksensitiven mikromechanischen Struktur verbunden sind, und zweite Kontaktierinseln, die außerhalb des Hohlraums angeordnet sind und mit der Schmelzstruktur verbunden sind. Des weiteren sind in der Teststruktur Leitbahnen vorgesehen, die eine Verbindung von der Schmelzstruktur zu den zweiten Kontaktierinseln und von der drucksensitiven mikromechanischen Struktur zu den ersten Kontaktierinseln bilden.

Auf Grund dieses Aufbaus der Teststruktur lässt sich das Dichtigkeitsverhalten der durch Scheibenverbundprozesse gebildeten Teststruktur selbst, sowie die Dichtigkeit und damit das Bauteilverhalten von weiteren Bauelementen, die ggf. zusammen mit der Teststruktur unter Einsatz der gleichen Prozessparameter hergestellt wurden, bewerten.

In einer weiteren vorteilhaften Ausführungsform weist die Schmelzstruktur eine Sollschmelzstelle auf. Damit lassen sich definierte Zustände beim Schmelzen und Verdampfen des Materials der Sollschmelzstelle erreichen.

In einer weiteren Ausführungsform sind mehrere Schmelzstellen in der Schmelzstruktur vorgesehen, wobei die Schmelzstellen durch das Design der Struktur definiert sind, wodurch der Schmelzvorgang in begrenzter Anzahl nacheinander wiederholt werden kann.

Mit einer derartigen Anordnung ist es möglich, mehr als einen Druckänderungsprozess in der Teststruktur hervorzurufen, so dass detailliertere Untersuchungen möglich sind. Beispielsweise können damit die diversen Phasen des Herstellungsprozesses untersucht werden, da entsprechende Dichtigkeitsprüfungen mehrmals in zeitlicher Abfolge durchgeführt werden können.

Des weiteren ermöglicht das Vorsehen mehrerer Sollschmelzstellen eine effiziente Online-Überwachung der Teststruktur und damit ggf. auch im Verband dazu vorliegender anderer MEMS-Strukturen, da Dichtigkeitsprüfungen während verschiedener Betriebsphasen der Teststruktur bzw. dieser zugeordneten MEMS-Strukturen durchgeführt werden können. Des weiteren bietet sich die Möglichkeit an, die Teststruktur mehrmals unter jeweils verschiedenen Stress-Bedingungen zu untersuchen, so dass auf der gleichen Chipfläche eine sehr detaillierte Prüfung in lokaler Weise durchgeführt werden kann.

In einer weiteren vorteilhaften Ausführungsform ist die Schmelzstruktur aus Metall aufgebaut und bei Stromfluss schmelzende Teile im Innenbereich verlaufen mäanderförmig.

Auf Grund dieses Aufbaus ergibt sich eine äußerst kompakte und fertigungstechnisch effiziente Struktur.

In einer weiteren Ausführungsform weist das Metall der Schmelzstruktur Aluminium auf.

Gemäß einem weiteren Aspekt der Erfindung wird eine Scheibenverbindung bereitgestellt, die eine mikroelektromechanische Struktur (MEMS) und eine Teststruktur zur Bewertung der Dichtigkeit der Scheibenverbindung umfasst, die so aufgebaut ist, wie dies in den vorhergehenden Ausführungsformen beschrieben ist.

In einer weiteren Ausführungsform sind mehrere Teststrukturen und mehrere mikroelektromechanische Strukturen vorgesehen sind.

Auf diese Weise lassen sich Messdaten vor dem Vereinzeln der Bauelemente in sehr effizienter Weise gewinnen, wie dies bereits beschrieben ist.

In einer weiteren Ausführungsform sind die mehreren Teststrukturen gemäß den Kriterien zur Qualitätssicherung der mehreren mikroelektromechanischen Strukturen angeordnet.

In einer weiteren Ausführungsform sind die Teststruktur und die mikroelektromechanische Struktur als Verband angeordnet sind. Dadurch tritt nach dem Vereinzeln der Bauelemente der Verband als funktionelle Einheit auf und lässt eine Online-Überwachung zu.

Weitere vorteilhafte Ausführungsformen, Merkmale und Vorteile gehen auch aus der folgenden detaillierten Beschreibung sowie den angefügten Patentansprüchen hervor.

In der folgenden detaillierten Beschreibung weiterer anschaulicher Ausführungsbeispiele wird auf die Zeichnungen verwiesen, die einen Bestandteil der Beschreibung bilden, wobei:
- Figur 1: eine Schnittansicht und eine Draufsicht auf eine Scheibenverbindung mit einer Teststruktur zeigt, und
- Figur 2: schematisch eine Draufsicht auf eine Scheibenverbindung mit mehreren Teststrukturen und mehreren mikroelektromechanischen Strukturen (MEMS) zeigt.

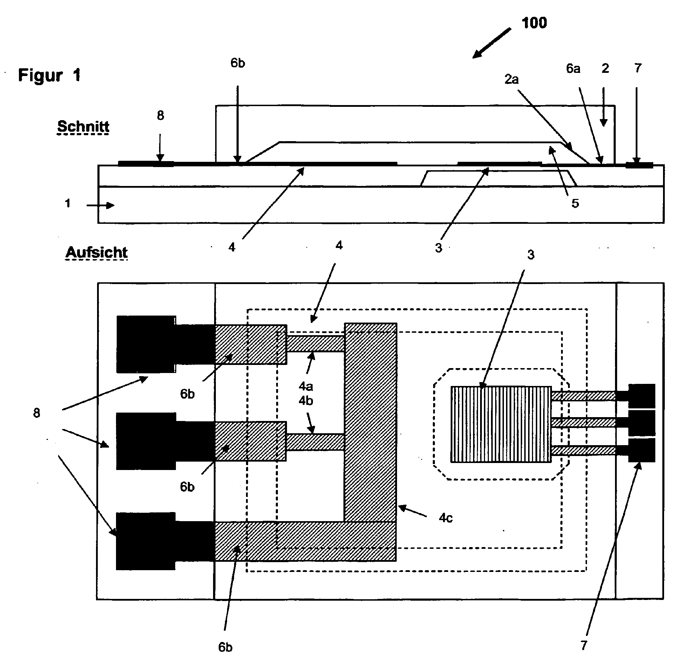

Figur 1 zeigt im oberen Teil des Bildes schematisch den Aufbau einer Teststruktur 100 im Querschnitt. Die Teststruktur 100 umfasst eine Basisscheibe 1 bzw. einen Bereich davon, die beispielsweise in Form einer Siliziumscheibe, einer Glasscheibe oder einem anderen geeigneten Träger vorgesehen sein kann. Des weiteren ist eine Deckscheibe 2 bzw. eine Bereich davon mit Einsenkungen 2a über der Basisscheibe 1 so angeordnet, dass ein Hohlraum bzw. eine Kavität 5 gebildet ist. In dem Hohlraum 5 ist eine drucksensitive Sensorstruktur 3 angeordnet, die mittels Leitbahnen 6a mit entsprechenden Kontaktierinseln 7 verbunden ist. Die Leitbahnen 6a sind so ausgebildet, dass diese von den außerhalb des Hohlraums 5 liegenden Kontaktierinseln 7 eine elektrische Verbindung zu der drucksensitiven Sensorstruktur 3 bilden, wobei die hermetische Dichtheit des Hohlraums 5 im Wesentlichen gewahrt bleibt. Ferner umfasst die Teststruktur 100 eine Schmelzstruktur 4, die eine oder mehrere Sollschmelzstellen aufweist. In der Draufsicht auf die Struktur 100, die in den unteren Teil der Fig. 1 dargestellt ist, ist die Schmelzstruktur 5 mit zwei Sollschmelzstellen 4a, 4b gezeigt, wobei in anderen Ausführungsformen eine oder mehr als zwei Sollschmelzstellen 4a, 4b vorgesehen sein können. Die Schmelzstruktur 4 ist in einer vorteilhaften Ausführungsform aus Metall aufgebaut, beispielsweise Aluminium, so dass hierbei auf gut bewährte Metallisierungsverfahren bei der Herstellung der Struktur 4 zurückgegriffen werden kann, die im Stand der Technik der Halbleitertechnologie bekannt sind. Ferner kann die Leiterführung in den Sollschmelzstellen 4a, 4b mäanderförmig vorgesehen sein. Die Sollschmelzstellen 4a, 4b sind über eine gemeinsame Elektrode 4c und mehrere Leitbahnen 6b mit entsprechenden Kontaktierinseln 8 verbunden.

In dem dargestellten Ausführungsbeispiel können die Sollschmelzstellen 4a, 4b wahlweise individuell oder gemeinsam durch Anlegen einer geeigneten Spannung zwischen der mit der gemeinsamen Elektrode 4c direkt verbundenen Kontaktierinsel 8 und den mit den entsprechenden Sollschmelzstellen 4a, 4b direkt verbundenen Kontaktierinseln 8 angesteuert werden. Ebenso wie bei der drucksensitiven Sensorstruktur 3 bilden die Leitbahnen 6b eine Verbindung zwischen den Kontaktierinseln 8 und den Sollschmelzstellen 4a, 4b und der Gegenelektrode 4c derart, dass die Dichtigkeit des Hohlraums 5 im Wesentlichen bewahrt bleibt.

Bei der Herstellung der Teststruktur 100 wird bei der Verbindung der Basisscheibe 1 mit der Deckscheibe 2 der Hohlraum 5 geschaffen, in welchem die Schmelzstruktur 4 und die drucksensitive Struktur 3 sodann gemeinsam angeordnet sind, wobei diese zuvor auf der Basisscheibe 1 durch aus der Halbleitertechnologie bekannte Herstellungsverfahren gebildet wurden. Die Teststrukturen 100 können dabei in zahlreicher Form auf der Basisscheibe 1 vorgesehen werden, wobei die Anzahl und die Lage der Teststrukturen 100 beispielsweise auf der Grundlage der Prinzipien der Qualitätskontrolle erfolgen kann, wenn die Teststrukturen 100 zur Qualitätsüberwachung bei der Fertigung von Scheibenverbundstrukturen verwendet werden sollen, die entsprechende MEMS-Strukturen enthalten, die ebenfalls einen Hohlraum aufweisen, dessen Dichtigkeit es zu überprüfen gilt.

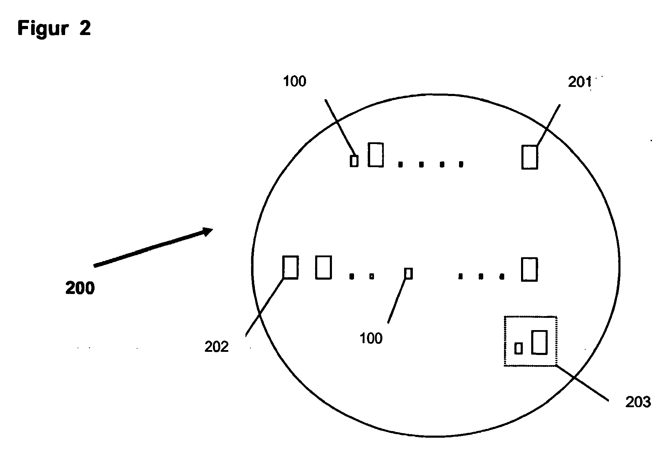

Fig. 2 zeigt schematisch eine Draufsicht einer typischen Scheibenverbindung bzw. Verbundhalbleiterscheibe 200, wie sie zur Fertigung von MEMS-Strukturen und Teststrukturen der vorliegenden Erfindung verwendet werden kann. Hierbei sind mehrere Teststrukturen 100 über die Scheibe 200 hinweg verteilt angeordnet, um damit ggf. lokale Fluktuationen des gesamten Fertigungsprozesses für die Scheibe 200 ermitteln zu können. In der gezeigten Ausführungsform sind hierbei auch eine oder mehrere MEMS-Strukturen 201 vorgesehen, die ebenfalls einen Hohlraum, ähnlich dem Hohlraum 5 aus Fig. 1, aufweisen können, in welchem ein mikromechanisches Sensorelement angeordnet sein kann. In der gezeigten Ausführungsform sind jeweils ein Verband 203 aus einer Teststruktur 100 und einer MEMS 201 gezeigt, so dass bei einer Vereinzelung der einzelnen funktionalen Elemente der Scheibe 200 beispielsweise eine Teststruktur 100 zusammen mit einer MEMS 201 als funktionale Einheit erhalten wird. In anderen Anwendungsbeispielen, sind die Teststrukturen 100 im Hinblick auf verfügbare Chipfläche sowie auf eine möglichst hohe statistische Relevanz entsprechender Messergebnisse verteilt. Des weiteren kann die Scheibe 200 lediglich Teststrukturen 100 oder gemeinsam Teststrukturen 100 und MEMS 201 aufweisen, wobei bei der Vereinzelung die Teststrukturen 100 einzeln bereitgestellt werden, so dass diese dann für weitere Verwendungszwecke vorgesehen werden können.

Wie zuvor bereits erwähnt ist, können bei der Fertigung der Teststruktur 100 und/oder der MEMS 201 Prozessparameterfluktuationen auftreten, die den Herstellungsprozess beeinträchtigen können. Des weiteren können bei der Entwicklung entsprechender Herstellungsverfahren die Bedeutung bzw. der Einfluss der einzelnen Prozessparameter unter Umständen nicht exakt vorhergesagt werden, so dass eine Bewertung des Bauteilzustandes während gewisser Herstellungsphasen Aufschluss über die Bedeutung einzelner Prozessparameter bringen kann. In anderen Anwendungsbereichen, beispielsweise, wenn die Teststruktur 100 als Verband 203 mit der MEMS 201 als funktionale Einheit gebildet wird, kann der Status der funktionalen Einheit und damit der MEMS 201 durch Messdaten ermittelt werden, die durch Betreiben der Teststruktur 100 gewonnen werden können. Insbesondere lässt sich damit eine Online-Überwachung der MEMS 201 erreichen.

Beim Betreiben der Teststruktur wird über ausgewählte Leitbahnen 6b der Schmelzstruktur 4 ein geeigneter Strom eingeprägt, so dass die entsprechend angesteuerte Sollschmelzstelle 4a, 4b schmilzt und dabei verdampft. Beispielsweise kann in der in Figur 1 unten gezeigten Ausführungsform durch Anlegen einer Spannung an die oberste und die unterste Kontaktierinsel 8 ein entsprechender Stromfluss durch die Sollschmelzstelle 4a stattfinden. Dabei können vor und/oder während und nach dem Durchschmelzen der entsprechenden Sollschmelzstelle 4a, 4b über die Kontaktierinseln 7 gewonnene elektrische Signale, die den Druck im Innenbereich des Hohlraums 5 repräsentieren, gewonnen werden, wobei der Verlauf des Druckes, der sich auf Grund des Schmelz- bzw. Verdampfungsvorganges ändert, Hinweise gibt über die Dichtigkeit des Hohlraums 5. D. h., der zeitliche Verlauf der gemessenen Druckwerte gibt Aufschluss über die Dichtigkeit der Scheibenverbindung. Somit lässt sich beispielsweise nach Abschluss einer gewissen Herstellungsphase, in der die Teststruktur 100 bereits funktionsfähig ist, die Qualität der Dichtigkeit des Hohlraums 5 bewerten, woraus sich auch ein Rückschluss auf die Dichtigkeit entsprechender Hohlräume in den MEMS 201 ergibt. Hierbei kann die Verteilung der Teststrukturen 100 auf der Scheibe, beispielsweise der Scheibe 200, so erfolgen, dass den Prinzipien der Fertigungskontrolle Rechnung getragen wird, wenn das Verfahren zur Qualitätsüberwachung bei der MEMS-Scheibenfertigung eingesetzt wird. Des weiteren lässt sich die Teststruktur 100 auch als vereinzeltes Element einsetzen oder es kann als der Verband 203 mit dem MEMS 201 zusammen verwendet werden, so dass sie beispielsweise bei parallelem Einsatz in sicherheitsrelevanten MEMS-Bauelementen als sogenannte Online-Überwachung dienen kann.

Beim Betreiben der Teststruktur 100, wenn in dieser mehrere Sollschmelzstellen 4a, 4b vorgesehen sind, können diese gleichzeitig oder selektiv zum Schmelzen gebracht werden. In einer Betriebsweise können beispielsweise die Sollschmelzstellen 4a, 4b aus Fig. 1 zeitlich nacheinander zum Schmelzen gebracht werden, so dass sich entsprechende Messergebnisse zu verschiedenen Zeiten ermitteln lassen. Auf diese Weise lässt sich sowohl eine effiziente Online-Überwachung von MEMS-Bauelementen realisieren, sowie auch eine sehr effiziente Überwachung des Fertigungsprozesses sowie eine Bewertung der Zuverlässigkeit der Scheibenverbindung erreichen. Zu diesem Zwecke kann die Teststruktur 100 einem Belastungstest unterzogen werden, in welchem vorgegebene Stress-Bedingungen eingestellt werden, um die entsprechenden Auswirkungen auf das Verhalten der Teststruktur 100 und damit ggf. auf die MEMS 201 zu untersuchen. Zum Beispiel kann die Teststruktur 100 zur Bewertung der Dichtigkeit des Hohlraums 5, woraus sich dann weitere Hinweise über die Zuverlässigkeit der Teststruktur 100 und damit der Scheibenverbindung 200 gewinnen lassen, durch Verwendung der Sollschmelzstelle 4a in einem ersten vorgegebenen Zustand verwendet werden. Danach können vorgegebene Stress-Bedingungen ausgeübt werden, beispielsweise kann die Scheibe bei hohen oder tiefen Temperaturen, bei hoher und tiefer Feuchtigkeit, bei Einwirkung mechanischer Kräfte, etc. betrieben bzw. gehalten werden. Während oder nach einer derartigen Einwirkung einer vorgegebenen Stress-Situation kann die Teststruktur 100 erneut mittels der Sollschmelzstelle 4b betrieben werden, um damit einen entsprechenden Einfluss der Stress-Situation auf die Zuverlässigkeit der Teststruktur 100 und damit der Scheibenverbindung 200 und/oder der MEMS 201 zu ermitteln. Selbstverständlich können derartige Stress-Untersuchungen auch mit nur einer einzelnen Sollschmelzstelle durchgeführt werden.

Mit Bezug zur Figur 1 seien jetzt noch weitere Ausführungsformen beschrieben. Ein Verfahren zur Bewertung der Dichtigkeit von Scheibenverbindungen, insbesondere beim Bonden von Scheiben zur Herstellung von mikro-elektromechanischen Strukturen (MEMS), bei denen sich der mikro-mechanische Sensorteil in einem hermetisch dicht geschlossenen Hohlraum (Kavität) 5 befindet, zeichnet sich des weiteren aus, dass verteilt auf die Scheibenfläche an bestimmten Stellen zusätzlich zu den MEMS mikromechanische Sensorstrukturen 3 und benachbart zu diesen Schmelzstrukturen 4 mit elektrischen Leitbahnen 6 und außerhalb der Kavität liegenden Kontaktierinseln 7 und 8 so hergestellt werden, dass jeweils ein mikromechanischer Sensor 3 und eine Schmelzstruktur 4 nach der Scheibenverbindung mit der die Hohlräume für die MEMS und die Teststruktur bildenden Deckscheibe 2 in ein und demselben Hohlraum 5 zu liegen kommen, dass nach dem Scheibenverbindungsprozeß zum Zweck der Dichtigkeitsprüfung über die elektrischen Außenkontakte 8 mittels eines Stromes die Schmelzstruktur 4 zum Schmelzen gebracht wird, wodurch eine Druckänderung im Innenbereich des Hohlraumes 5 erzeugt wird, welche in ihrem zeitlichen Verlauf mit Hilfe der Sensorstruktur 3 gemessen wird.

Ferner wird die unter dem veränderten Druck stehende Teststruktur gezielt gestresst wird (Temperatur/ Feuchte/ mechanisch usw.) und es werden durch Vergleich der Meßwerte der drucksensitiven Struktur 3 vor und nach dem Stress Aussagen zur Zuverlässigkeit gewonnen.

Eine Teststruktur, die nach dem vorhergehenden Verfahren arbeitet, zeichnet sich dadurch aus, daß die Schmelzstruktur 4 aus Metall besteht, und die bei Stromfluß schmelzenden Teile im Innenbereich 5 mäanderförmig verlaufen.

Ferner besteht in einer Ausführungsform die Teststruktur aus Aluminium.

Ferner sind in einer Ausführungsform mehrere Schmelzstellen in der Schmelzstruktur 4 vorhanden, wobei die Sollschmelzstellen durch das Design der Struktur definiert sind, wodurch der Schmelzvorgang in begrenzter Anzahl nacheinander wiederholt werden kann.

## Patentansprüche

1. **Verfahren zur Bewertung** der Dichtigkeit einer Scheibenverbindung (200), wobei das Verfahren umfasst
- Herstellen einer Teststruktur (100) durch
-- Bilden einer mikromechanischen Sensorstruktur (3) und einer benachbarten Schmelzstruktur (4) mit elektrischen Leitbahnen (6a,6b) und ersten Kontaktierinseln (7), die mit der mikromechanischen Sensorstruktur (3) verbunden sind, und zweiten Kontaktierinseln (8), die mit der Schmelzstruktur (4) verbunden sind, auf einer Basisscheibe (1),
-- Schaffen eines Hohlraums (5) durch Verbinden einer Deckscheibe (2) mit der Basisscheibe (1) so, dass die mikromechanische Sensorstruktur (3) und die Schmelzstruktur (4) in dem Hohlraum (5) liegen;
- Einprägen eines Stromes in die zweiten Kontaktierinseln (8), um die Schmelzstruktur (4) zum Zwecke der Dichtigkeitsprüfung des Hohlraums (5) zum Schmelzen zu bringen, wodurch eine Druckänderung im Innenbereich des Hohlraums (5) erzeugt wird, welche Änderung einen zeitlichen Verlauf aufweist, der mit Hilfe der mikromechanischen Sensorstruktur (3) gemessen wird.

2. Verfahren nach Anspruch 1, das ferner umfasst: Herstellen mehrerer mikroelektromechanischen Strukturen (201) auf der Scheibenverbindung (200).

3. Verfahren nach Anspruch 2, wobei mehrere Teststrukturen (100) an bestimmten Stellen der Scheibenverbindung (200) hergestellt werden.

4. Verfahren nach Anspruch 3, wobei die mehreren Teststrukturen (100) entsprechend vorgegebenen Kriterien der Qualitätsüberwachung für die mikroelektromechanischen Strukturen (201) angeordnet werden.

5. Verfahren nach einem der Ansprüche 1 bis 5, wobei die unter dem veränderten Druck stehende Teststruktur (100) gezielt Stress-Bedingungen ausgesetzt wird und wobei durch Vergleich der Messwerte der mikromechanischen Sensorstruktur (3) vor und nach dem Ausüben der Stressbedingung Aussagen zur Zuverlässigkeit gewonnen werden.

6. **Verfahren** zur Überwachung der Funktion einer mikroelektromechanischen Struktur (201), wobei das Verfahren umfasst:
- Herstellen einer Teststruktur (100) durch:
-- Bilden einer mikromechanischen Sensorstruktur (3) und einer benachbarten Schmelzstruktur (4) mit elektrischen Leitbahnen (6a,6b) und ersten Kontaktierinseln (7), die mit der mikromechanischen Sensorstruktur (3) verbunden sind, und zweiten Kontaktierinseln (8), die mit der Schmelzstruktur (4) verbunden sind, auf einer Basisscheibe (1);
-- Schaffen eines Hohlraums (5) durch Verbinden einer Deckscheibe (2) mit der Basisscheibe (1) so, dass die mikromechanische Sensorstruktur (3) und die Schmelzstruktur (4) in dem Hohlraum (5) liegen,
- Herstellen der mikroelektromechanischen Struktur (201) so, dass diese einen funktionellen Verband mit der Teststruktur (100) bildet,
- Betreiben der mikroelektromechanischen Struktur (201),
- Einprägen eines Stromes in die Schmelzstruktur (4) der Teststruktur (100);
- Auswerten der Messwerte der mikromechanischen Sensorstruktur (3), um eine Online-Überwachung der mikroelektromechanischen Struktur (201) durchzuführen.

7. Verfahren nach Anspruch 6, wobei die Schmelzstruktur (4) der Teststruktur (100) mehrere Sollschmelzstellen (4a, 4b) aufweist, und wobei das Verfahren ferner umfasst: Auslösen eines Schmelzvorgangs der mehreren Sollschmelzstellen nacheinander und Bewerten der Messergebnisse, die von der mikromechanischen Sensorstruktur (3) erhalten werden, um die Online-Überwachung auszuführen.

8. **Teststruktur** zur Bewertung der Dichtigkeit einer Scheibenverbindung, mit
- einem Bereich einer Basisscheibe (1) und einem Bereich einer Deckscheibe (2),
- einem Hohlraum (5), der durch eine Scheibenverbindung der Basisscheibe (1) und der Deckscheibe (2) gebildet ist,
- einer drucksensitiven mikromechanischen Struktur (3), die in dem Hohlraum (5) angeordnet ist,
- einer Schmelzstruktur (4), die in dem Hohlraum (5) angeordnet ist,
- ersten Kontaktierinseln (7), die außerhalb des Hohlraums (5) liegen und mit der drucksensitiven mikromechanischen Struktur (3) verbunden sind,
- zweiten Kontaktierinseln (8), die außerhalb des Hohlraums (5) angeordnet sind und mit der Schmelzstruktur (4) verbunden sind,
- Leitbahnen (6a, 6b), die eine Verbindung von der Schmelzstruktur (4) zu den zweiten Kontaktierinseln (8) und von der drucksensitiven mikromechanischen Struktur (3) zu den ersten Kontaktierinseln (7) bilden.

9. Teststruktur nach Anspruch 8, wobei die Schmelzstruktur eine Sollschmelzstelle (4a,4b) umfasst.

10. Teststruktur nach Anspruch 8 und/oder 9, wobei die Schmelzstruktur aus Metall aufgebaut ist.

11. Teststruktur nach Anspruch 10, wobei das Metall Aluminium enthält.

12. Teststruktur nach Anspruch 11, wobei bei Stromfluss schmelzende Teile der Schmelzstruktur (4) im Hohlraum (5) mäanderförmig verlaufen.

13. Teststruktur nach mindestens einem der Ansprüche 8 bis 12, wobei mehrere Sollschmelzstellen (4a,4b) in der Schmelzstruktur (4) vorgesehen sind und wobei die Sollschmelzstellen (4a, 4b) durch das Design der Schmelzstruktur (4) definiert sind, wodurch ein Schmelzvorgang in begrenzter Anzahl nacheinander wiederholbar ist.

14. **Scheibenverbindung** (200), die umfasst
- eine Teststruktur (100) zur Bewertung der Dichtigkeit der Scheibenverbindung (200) mit
- einer Basisscheibe (1) und einer Deckscheibe (2),
- einem Hohlraum (5), der durch Scheibenverbindung der Basisscheibe (1) und der Deckscheibe (2) gebildet ist,
- einer drucksensitiven mikromechanischen Struktur (3), die in dem Hohlraum (5) angeordnet ist,
- einer Schmelzstruktur (4), die in dem Hohlraum (5) angeordnet ist,
- ersten Kontaktierinseln (7), die außerhalb des Hohlraums (5) liegen und mit der drucksensitiven mikromechanischen Struktur (3) verbunden sind,
- zweiten Kontaktierinseln (8), die außerhalb des Hohlraums (5) angeordnet sind und mit der Schmelzstruktur (4) verbunden sind und
- Leitbahnen (6a,6b), die eine Verbindung von der Schmelzstruktur (4) zu den zweiten Kontaktierinseln (8) und von der drucksensitiven mikromechanischen Struktur (3) zu den ersten Kontaktierinseln (7) bilden,
- eine mikroelektromechanische Struktur (201).

15. Scheibenverbindung nach Anspruch 14, wobei mehrere Teststrukturen (100) und mehrere mikroelektromechanische Strukturen (201) vorgesehen sind.

16. Scheibenverbindung nach Anspruch 15, wobei die mehreren Teststrukturen (100) gemäß den Kriterien zur Qualitätssicherung der mehreren mikroelektromechanischen Strukturen (201) angeordnet sind.

17. Scheibenverbindung nach Anspruch 14 oder 15, wobei die Teststruktur (100) und die mikroelektromechanische Struktur (201) als Verband angeordnet sind.

## Claims

1. A method for evaluating the tightness of a disc connection (200), wherein the method comprises
- producing a test structure (100) by
-- forming a micromechanical sensor structure (3) and an adjacent melt structure (4) with electric conductor paths (6a, 6b) and first contacting islands (7), which are connected to the micromechanical sensor structure (3), and second contacting islands (8), which are connected to the melt structure (4), on a base disc (1),
-- creating a cavity (5) by connecting a top disc (2) to the base disc (1) so the micromechanical sensor structure (3) and the melt structure (4) lie in the cavity (5);
- impressing a current into the second contact islands (8) in order to make the melt structure melt for the purpose of testing the tightness of the cavity (5), so a pressure change in the inner region of the cavity (5) is produced, which change has a time course, which is measured with the aid of the micromechanical sensor structure (3).

2. A method according to claim 1, further comprising: producing a plurality of microelectromechanical structures (201) on the disc connection (200).

3. A method according to claim 2, wherein a plurality of test structures (100) are produced at specific points of the disc connection (200).

4. A method according to claim 3, wherein the plurality of test structures (100) are arranged in accordance with predetermined criteria of the quality monitoring for the microelectromechanical structures (201).

5. A method according to any one of claims 1 to 5, wherein the test structure (100) under the changed pressure is subjected in a targeted manner to stress conditions and wherein by comparing the measured values of the micromechanical sensor structure (3) before and after the exertion of the stress condition, information is obtained about the reliability.

6. A method for monitoring the function of a microelectromechanical structure (201), wherein the method comprises
- producing a test structure (100) by:
-- forming a micromechanical sensor structure (3) and an adjacent melt structure (4) with electric conductor paths (6a, 6b) and first contacting islands (7), which are connected to the micromechanical sensor structure (3), and second contacting islands (8), which are connected to the melt structure (4), on a base disc (1);
-- creating a cavity (5) by connecting a top disc (2) to the base disc (1) so the micromechanical sensor structure (3) and the melt structure (4) lie in the cavity (5),
- producing the microelectromechanical structure (201) such that the latter forms a functional assembly with the test structure (100),
- operating the microelectromechanical structure (201),
- impressing a current into the melt structure (4) of the test structure (100);
- evaluating the measured values of the micromechanical sensor structure (3) to carry out on-line monitoring of the microelectromechanical structure (201).

7. A method according to claim 6, wherein the melt structure (4) of the test structure (100) has a plurality of desired melting points (4a, 4b), and wherein the method further comprises: triggering a melting process of the plurality of desired melting points one after the other and evaluating the measuring results, which are obtained by the micromechanical sensor structure (3) in order to carry out the on-line monitoring.

8. A test structure for evaluating the tightness of a disc connection, comprising
- a region of a base disc (1) and a region of a top disc (2),
- a cavity (5), which is formed by a disc connection of the base disc (1) and the top disc (2),
- a pressure-sensitive micromechanical structure (3), which is arranged in the cavity (5),
- a melt structure (4), which is arranged in the cavity (5),
- first contacting islands (7), which are located outside the cavity (5) and are connected to the pressure-sensitive micromechanical structure (3),
- second contacting islands (8) which are arranged outside the cavity (5) and are connected to the melt structure (4),
- conductor paths (6a, 6b), which form a connection from the melt structure (4) to the second contacting islands (8) and from the pressure-sensitive micromechanical structure (3) to the first contacting islands (7).

9. A test structure according to claim 8, wherein the melt structure comprises a desired melting point (4a, 4b).

10. A test structure according to claim 8 and/or 9, wherein the melt structure is built up from metal.

11. A test structure according to claim 10, wherein the metal contains aluminium.

12. A test structure according to claim 11, wherein parts of the melt structure (4) which melt upon current flow extend in a meandering manner in the cavity (5).

13. A test structure according to at least any one of claims 8 to 12, wherein a plurality of desired melting points (4a, 4b) are provided in the melt structure (4) and wherein the desired melting points (4a, 4b) are defined by the design of the melt structure (4), so a melting process can be repeated in a limited number one after the other.

14. A disc connection (200), which comprises
- a test structure (100) for evaluating the tightness of the disc connection (200) comprising
- a base disc (1) and a top disc (2),
- a cavity (5), which is formed by the disc connection of the base disc (1) and the top disc (2),
- a pressure-sensitive micromechanical structure (3), which is arranged in the cavity (5),
- a melt structure (4), which is arranged in the cavity (5),
- first contacting islands (7), which lie outside the cavity (5) and are connected to the pressure-sensitive micromechanical structure (3),
- second contacting islands (8), which are arranged outside the cavity (5) and are connected to the melt structure (4) and
- conductor paths (6a, 6b), which form a connection from the melt structure (4) to the second contacting islands (8) and from the pressure-sensitive micromechanical structure (3) to the first contacting islands (7),
- a microelectromechanical structure (201).

15. A disc connection according to claim 14, wherein a plurality of test structures (100) and a plurality of microelectromechanical structures (201) are provided.

16. A disc connection according to claim 15, wherein the plurality of test structures (100) are arranged in accordance with the criteria for quality assurance of the plurality of microelectromechanical structures (201).

17. A disc connection according to claim 14 or 15, wherein the test structure (100) and the microelectromechanical structure (201) are arranged as an assembly.

## Revendications

1. Procédé pour évaluer l'étanchéité d'un assemblage de plaques (200), lequel procédé comprend:
- la fabrication d'une structure d'essai (100)
-- en formant une structure de capteur micromécanique (3) et une structure de fusion adjacente (4) comprenant des pistes conductrices d'électricité (6a, 6b) et des premiers îlots de contact (7), qui sont connectés à la structure de capteur micromécanique (3), et des seconds îlots de contact (8), qui sont connectés à la structure de fusion (4), sur une plaque de base (1) ;
-- en ménageant une cavité (5) par assemblage d'une plaque de couverture (2) avec la plaque de base (1), de sorte que la structure de capteur micromécanique (3) et la structure de fusion (4) se trouvent dans la cavité (5) ;
- l'application d'un courant dans les seconds îlots de contact (8) pour amener la structure de fusion (4) à fondre dans le but de vérifier l'étanchéité de la cavité (5), ce qui entraîne une modification de pression dans la zone interne de la cavité (5), laquelle modification présente une variation en fonction du temps, qui est mesurée à l'aide de la structure de capteur micromécanique (3).

2. Procédé selon la revendication 1, comprenant en outre la fabrication de multiples structures microélectromécaniques (201) sur l'assemblage de plaques (200).

3. Procédé selon la revendication 2, dans lequel on fabrique de multiples structures d'essai (100) en des points déterminés de l'assemblage de plaques (200).

4. Procédé selon la revendication 3, dans lequel les multiples structures d'essai (100) sont aménagées en fonction de critères prédéterminés de surveillance de qualité pour les structures microélectromécaniques (201).

5. Procédé selon l'une quelconque des revendications 1 à 5, dans lequel la structure d'essai (100) placée sous l'action de la modification de pression est soumise à des conditions de stress déterminées et dans lequel des données de fiabilité sont récoltées par comparaison des valeurs de mesure de la structure de capteur micromécanique (3) avant et après l'exposition à la condition de stress.

6. Procédé de surveillance du fonctionnement d'une structure microélectromécanique (201), lequel procédé comprend :
- la fabrication d'une structure d'essai (100)
-- en formant une structure de capteur micromécanique (3) et une structure de fusion adjacente (4) comprenant des pistes conductrices d'électricité (6a, 6b) et des premiers îlots de contact (7), qui sont connectés à la structure de capteur micromécanique (3), et des seconds îlots de contact (8), qui sont connectés à la structure de fusion (4), sur une plaque de base (1) ;
-- en ménageant une cavité (5) par assemblage d'une plaque de couverture (2) avec la plaque de base (1), de sorte que la structure de capteur micromécanique (3) et la structure de fusion (4) se trouvent dans la cavité (5);
- la fabrication de la structure microélectromécanique (201), de sorte que celle-ci forme un assemblage fonctionnel avec la structure d'essai (100) ;
- le fonctionnement de la structure microélectromécanique (201) ;
- l'application d'un courant dans la structure de fusion (4) de la structure d'essai (100) ; et
- l'exploitation des valeurs mesurées pour la structure de capteur micromécanique (3) afin d'assurer une surveillance en ligne de la structure microélectromécanique (201).

7. Procédé selon la revendication 6, dans lequel la structure de fusion (4) de la structure d'essai (100) présente plusieurs points de fusion théoriques (4a, 4b), et lequel procédé comprend en outre : le déclenchement d'un processus de fusion des multiples points de fusion théoriques, l'un après l'autre, et l'évaluation des résultats de mesure, qui sont reçus par la structure de capteur micromécanique (3) afin d'assurer la surveillance en ligne.

8. Structure d'essai pour évaluer l'étanchéité d'un assemblage de plaques, comprenant:
- une zone formée d'une plaque de base (1) et une zone formée d'une plaque de couverture (2),
- une cavité (5), qui est formée par un assemblage de la plaque de base (1) et de la plaque de couverture (2),
- une structure micromécanique sensible à la pression (3), qui est placée dans la cavité (5),
- une structure de fusion (4) qui est placée dans la cavité (5),
- des premiers îlots de contact (7), qui se situent en dehors de la cavité (5) et sont connectés à la structure micromécanique sensible à la pression (3),
- des seconds îlots de contact (8), qui sont disposés en dehors de la cavité (5) et sont connectés à la structure de fusion (4),
- des pistes conductrices (6a, 6b), qui forment une connexion entre la structure de fusion (4) et les seconds îlots de contact (8) et entre la structure micromécanique sensible à la pression (3) et les premiers îlots de contact (7).

9. Structure d'essai selon la revendication 8, dans laquelle la structure de fusion comprend un point de fusion théorique (4a, 4b).

10. Structure d'essai selon l'une quelconque des revendications 8 et/ou 9, dans laquelle la structure de fusion est constituée de métal.

11. Structure d'essai selon la revendication 10, dans laquelle le métal contient de l'aluminium.

12. Structure d'essai selon la revendication 11, dans laquelle des parties de la structure de fusion (4) fondant sous l'influence d'un courant électrique s'écoulent en méandres dans la cavité (5).

13. Structure d'essai selon au moins l'une quelconque des revendications 8 à 12, dans laquelle plusieurs points de fusion théoriques (4a, 4b) sont prévus dans la structure de fusion (4) et dans laquelle les points de fusion théoriques (4a, 4b) sont définis par le modèle de la structure de fusion (4), ce qui permet de répéter successivement une opération de fusion en nombre limité.

14. Assemblage de plaques (200), comprenant :
- une structure d'essai (100) pour évaluer l'étanchéité de l'assemblage de plaques (200) avec
-- une plaque de base (1) et une plaque de couverture (2) ;
-- une cavité (5), qui est formée par assemblage de la plaque de base (1) et de la plaque de couverture (2) ;
-- une structure micromécanique sensible à la pression (3), qui est placée dans la cavité (5) ;
-- une structure de fusion (4), qui est placée dans la cavité (5) ;
-- des premiers îlots de contact (7), qui se situent en dehors de la cavité (5) et sont connectés à la structure micromécanique sensible à la pression (3);
-- des seconds îlots de contact (8), qui sont disposés en dehors de la cavité (5) et sont connectés à la structure de fusion (4) ; et
-- des pistes conductrices (6a, 6b), qui forment une connexion entre la structure de fusion (4) et les seconds îlots de contact (8) et entre la structure micromécanique sensible à la pression (3) et les premiers îlots de contact (7),
- une structure microélectromécanique (201).

15. Assemblage de plaques selon la revendication 14, dans lequel on prévoit de multiples structures d'essai (100) et de multiples structures microélectromécaniques (201).

16. Assemblage de plaques selon la revendication 15, dans lequel on aménage les multiples structures d'essai (100) en fonction des critères de surveillance de qualité des multiples structures microélectromécaniques (201).

17. Assemblage de plaques selon la revendication 14 ou 15, dans lequel la structure d'essai (100) et la structure microélectromécanique (201) sont aménagées sous la forme d'un assemblage.
